# FASCICULE DE BREVET EUROPEEN

(11) **EP 0 917 762 B1**
(45) Date de publication et mention de la délivrance du brevet: **22.10.2003**
(21) Numéro de dépôt: 97936753.9
(22) Date de dépôt: 07.08.1997
(51) Int. Cl.: H03K 3/57

(54) **CIRCUIT DE GENERATION D'IMPULSIONS DE COURANT A HAUTE TENSION DELIVRE DANS UN CIRCUIT DE CHARGE ET PROCEDE DE MISE EN OEUVRE**
SCHALTUNG ZUR ERZEUGUNG AN EINE LASTSCHALTUNG ANZULEGENDER HOCHSPANNUNGS-STROMIMPULSE SOWIE BETRIEBSVERFAHREN DAZU
CIRCUIT FOR GENERATING PULSES OF HIGH VOLTAGE CURRENT DELIVERED INTO A LOAD CIRCUIT AND IMPLEMENTING METHOD

(30) Priorité: 08.08.1996 FR 9610006
(43) Date de publication de la demande: 26.05.1999
(73) Titulaire: COMMISSARIAT A L'ENERGIE ATOMIQUE, 75015 Paris (FR)
(72) Inventeur: LE CAMPION, Christophe, F-91080 Courcouronnes (FR)
(74) Mandataire: Audier, Philippe André
(86) Numéro de dépôt international: FR9701466
(87) Numéro de publication internationale: WO98007235

(56) Documents cités:
- FR-A- 2 562 341
- US-A- 3 679 289
- US-A- 3 818 373
- US-A- 3 910 679
- US-A- 4 615 588
- US-A- 4 620 113
- US-A- 4 629 993
- US-A- 4 667 161
- US-A- 4 937 457
- US-A- 5 170 124
- US-A- 5 410 425
- Lasermetrics, Electro-Optics Division, CRE Group 1000 Electro-Optic Light Modulators, 1988
- Lasermetrics Division, Fastpulse Technology, Inc., 1040 SERIES POCKELS CELL ELECTRO-OPTIC LIGHT MODULATORS, sans date de publication, obtenu de l'internet le 27/09/2001
- Lasermetrics Division, Fastpulse Technology, Inc., Robert L. Goldstein, "User's Guide for KD*P & Lithium Niobate Q-Switches & Modulators for Q-Switching, Chopping & Pulse Extraction", publié pour la première fois environs Mai 1994; obtenu de l'Internet le 27/09/2001
- FastPulse Technology,Inc. Lasermetrics Division: Lasers & Applications April 1986, Robert Goldstein, "Electro-Optic Devices in Review - The Linear Electro-Optic (Pockels) Effect Forms the Basis for a Family of Active Devices"
- Kentech Instruments Ltd, "Pockels Cell Driver System for Pulse Slicing - Principles of Operation and Instructions for use", 10th. May 1995, Serial Number SN 95011
- "BROADBAND POCKELS CELL AND DRIVER FOR A MARK III-TYPE FREE ELECTRONLASER ", BECKER K; JOHNSON J B; EDWARDS G, REVIEW OF SCIENTIFIC INSTRUMENTS, AMERICAN INSTITUTE OF PHYSICS. NEW YORK, US, VOL. 65, NR. 5, PAGES 1496-1501, 1994-05-01 XP000454925
- "FAST LAMBDA/4 AND LAMBDA/2 VOLTAGE POCKETS CELL DRIVER FOR AN INTERNALLY SEEDED AND CAVITY DUMPED REGENERATIVE LASER AMPLIFIER" , DONG S; ET AL, REVIEW OF SCIENTIFIC INSTRUMENTS, AMERICAN INSTITUTE OF PHYSICS, NEW YORK, US, VOL. 57, NR. 4, PAGES 539-543, 1986-04-01 XP000712037
- BECKER K. ET AL: 'Broadband Pockels cell and driver for a Mark III-type free electron laser' REVIEW OF SCIENTIFIC INSTRUMENTS vol. 65, no. 5, 01 Mai 1994, pages 1496 - 1501

## Description

### Domaine de l'invention

L'invention concerne un circuit de génération d'impulsions de courant à haute tension délivré dans un circuit de charge et, plus particulièrement, dans un circuit de charge capacitive. Elle concerne également le procédé de mise en fonctionnement de ce circuit.

L'invention trouve des applications dans les techniques de transfert répété d'impulsions qui peuvent être à plusieurs kilovolts et de durées différentes et qui se succèdent à intervalles variables et, éventuellement, très brefs.

### Etat de la technique

Dans le domaine du transfert répété d'impulsions, les impulsions sont généralement produites par un générateur de courant qui est raccordé au circuit de dissipation, ou circuit de charge, par l'intermédiaire d'un interrupteur fermé ou ouvert à volonté. Cet interrupteur peut être un transistor. Plusieurs interrupteurs disposés en série peuvent remplacer l'interrupteur unique, si la tension aux bornes du circuit de dissipation l'exige. Un condensateur est ajouté pour stocker l'énergie nécessaire : il est branché entre le circuit de dissipation et le générateur de tension. Ce condensateur se charge quand l'interrupteur est ouvert et se décharge, dans'le circuit de dissipation, quand l'interrupteur se ferme. On observe alors une montée en tension suffisamment rapide dans le circuit de dissipation, mais seulement si l'impulsion précédente a cessé depuis quelques temps.

Or, il est souvent nécessaire d'obtenir des impulsions convenables, c'est-à-dire avec· des temps de montée et de descente très brefs, immédiatement après la fin d'une impulsion précédente.

Par ailleurs, le document US-A-3 910 679 décrit un système de sélection d'une impulsion à grande vitesse provenant d'un train d'impulsions produit par une source de radiation monochromatique. Ce système comporte deux circuits d'alimentation symétriques et une seule alimentation, commune aux deux circuits. Ces deux circuits d'alimentation sont aptes à charger, chacun, une cellule de Pockels et sont commandés, chacun, par un interrupteur réalisé au moyen d'une série de transistors. Ces interrupteurs se ferment avec un temps de retard l'un par rapport à l'autre.

Cependant, un tel système ne permet pas de rattraper les pertes entre deux retards de commutation.

Le document US-A-4 615 588 décrit un autre circuit de génération d'impulsions de courant à haute tension.

### Exposé de l'invention

L'invention a pour but de remédier aux inconvénients de la technique décrite précédemment.

A cette fin, elle propose un circuit de génération d'impulsions selon la revendication 1, comportant deux circuits d'alimentation haute tension, délivrant chacun un courant dans un même circuit de charge à deux instants différents. Ce circuit permet de générer des impulsions à fronts de montée et de descente carrés et dont la durée est contrôlable.

Plus précisément, l'invention concerne un circuit de génération d'impulsions de courant à haute tension comportant un premier circuit d'alimentation délivrant un premier courant dans un circuit de charge et comprenant un premier condensateur, un premier interrupteur connecté sur une borne du premier condensateur et un premier générateur de tension connecté également sur cette borne du premier condensateur. Ce circuit de génération d'impulsions se caractérise par le fait qu'il comporte un second circuit d'alimentation délivrant un second courant dans le circuit de charge et comportant un second condensateur, un second interrupteur connecté sur une borne du second condensateur et un second générateur de tension connecté également sur cette borne du second condensateur.

Selon un mode de réalisation de l'invention, le circuit de charge comporte deux charges capacitives connectées, respectivement, au premier circuit d'alimentation et au second circuit d'alimentation et formant une cellule de Pockels double.

Selon un autre mode de réalisation de l'invention, le circuit de charge comporte une charge capacitive connectée, par une première borne, au premier circuit d'alimentation et, par une seconde borne, au second circuit d'alimentation, de manière à former une cellule de Pockels simple.

L'invention concerne également un procédé de mise en fonctionnement de ce circuit de génération d'impulsions de courant à haute tension qui consiste à fermer le second interrupteur après avoir fermé le premier interrupteur, le temps écoulé entre les fermetures du premier et du second interrupteurs étant réglable.

### Brève description des figures

- La figure 1 représente un premier mode de réalisation du circuit de génération d'impulsions de l'invention ;
- la figure 2 représente un second mode de réalisation du circuit de génération d'impulsions de l'invention ;
- les figures 3A et 3B représentent le circuit de la figure 1 en fonctionnement, c'est-à-dire, respectivement, lorsque le premier interrupteur est fermé et lorsque le second interrupteur est fermé ;
- la figure 4 représente les diagrammes temporels de différentes tensions du circuit de la figure 1 lorsque celui-ci est en fonctionnement.

### Exposé de modes de réalisation de l'invention

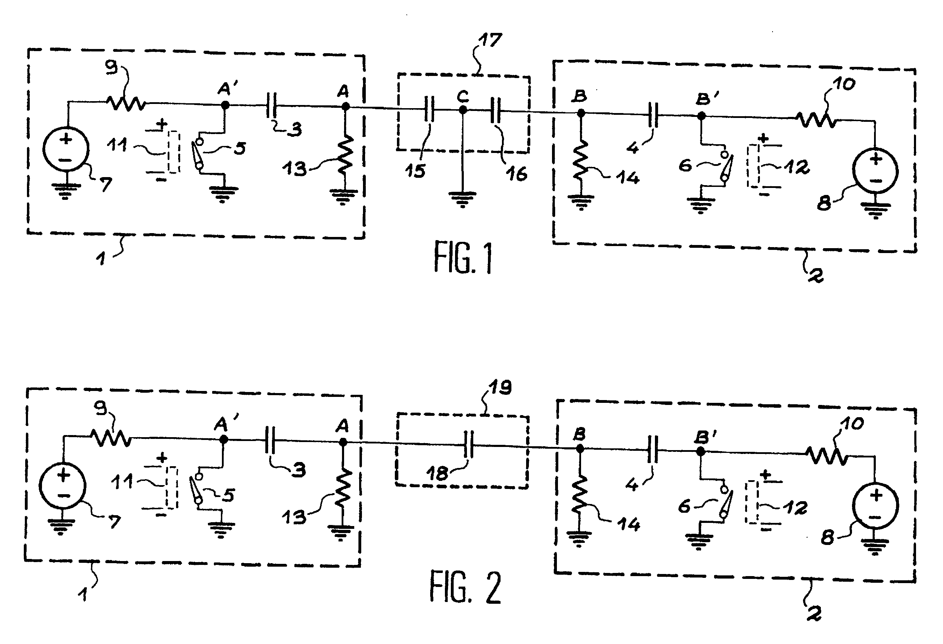

La figure 1 représente le circuit de génération d'impulsions selon le premier mode de réalisation de l'invention.

Ce circuit comporte un premier circuit d'alimentation haute tension à stockage capacitif, référencé 1, qui délivre un courant I_{Von} dans le circuit de charge 17.

Ce circuit d'alimentation 1 se présente sous la forme d'une dérivation entre les jonctions A et la masse ; cette dérivation comporte, successivement, un premier condensateur 3 et une jonction A' sur laquelle sont connectés, d'une part, un premier générateur de tension 7 et, d'autre part, un premier interrupteur 5. En outre, entre la jonction A' et le premier générateur de tension 7, se trouve une résistance 9 qui assure une limitation du courant du générateur.

Le premier interrupteur 5 est actionné à partir d'un circuit de commande 11. C'est ce circuit de commande 11 qui est responsable de l'ouverture et de la fermeture de l'interrupteur 5 et, par conséquent, de l'émission de courant par le circuit d'alimentation 1 vers le circuit de charge 17, comme cela sera expliqué plus en détail ultérieurement.

Une seconde dérivation entre la jonction A et la masse comporte une résistance 13 qui assure la décharge des condensateurs du générateur.

Le circuit d'alimentation 1 se raccorde donc à la jonction A sur laquelle est également raccordé le circuit de charge 17.

Symétriquement par rapport au circuit de charge 17, se trouve un second circuit d'alimentation haute tension à stockage capacitif, référencé 2.

Ce second circuit d'alimentation 2 est tout à fait symétrique, dans sa composition, au circuit d'alimentation 1. Il se présente sous la forme d'une dérivation entre la jonction B et la masse ; cette dérivation comporte un second condensateur 4, ainsi qu'une jonction B' sur laquelle sont connectés, d'une part, un second générateur de tension 8 précédé d'une résistance 10 de limitation du courant du générateur et, d'autre part, un second interrupteur 6 commandé par le circuit de commande 12.

Symétriquement à la résistance 13 connectée sur la jonction A, une résistance 14 est connectée en dérivation entre la jonction B et la masse. Cette résistance 14 a le même rôle, pour le circuit d'alimentation 2, que la résistance 13 pour le circuit d'alimentation 1.

Ainsi, chacun des circuits d'alimentation 1 et 2 est raccordé, symétriquement, sur une branche du circuit de charge 17.

Comme on le verra par la suite, le second circuit d'alimentation 2 délivre un courant I_{Voff} dans le circuit de charge 17, un certain temps après que le circuit d'alimentation 1 ait délivré son courant I_{Von}.

Selon le mode de réalisation représenté sur la figure 1, le circuit de charge 17 consiste en une cellule de Pockels double. Cette cellule de Pockels double comporte deux charges capacitives 15 et 16 raccordées l'une et l'autre, en un point C, à la masse.

Comme on le comprendra mieux par la suite, ce circuit de génération d'impulsions muni de deux circuits d'alimentation reliés chacun à un même circuit de charge permet de générer des impulsions ayant des temps de montée et de descente très brefs, ce qui se traduit, graphiquement, par des fronts montant et descendant carrés. En outre, un tel circuit permet de régler la largeur des impulsions produites, en modifiant l'intervalle de temps entre la commutation de l'interrupteur 5 et celle de l'interrupteur 6.

Sur la figure 2, on a représenté le circuit de génération d'impulsions conforme à un second mode de réalisation de l'invention.

Tout comme le mode de réalisation de la figure 1, ce circuit comporte un premier et un second circuits d'alimentation 1 et 2 identiques à ceux décrits précédemment. Ils ne seront donc pas décrits à nouveau.

Ces deux circuits d'alimentation 1 et 2 sont raccordés tous deux à un circuit de charge 19 qui consiste en une cellule de Pockels simple. Celle-ci comporte une seule charge capacitive 18.

Ce circuit de la figure 2 fonctionne de façon similaire à celui de la figure 1. Seuls les temps de montée et de descente des impulsions sont un peu moins rapides que pour un circuit muni d'une cellule de Pockels double, mais ils restent tout de même suffisamment rapides pour que l'on obtienne des impulsions carrées.

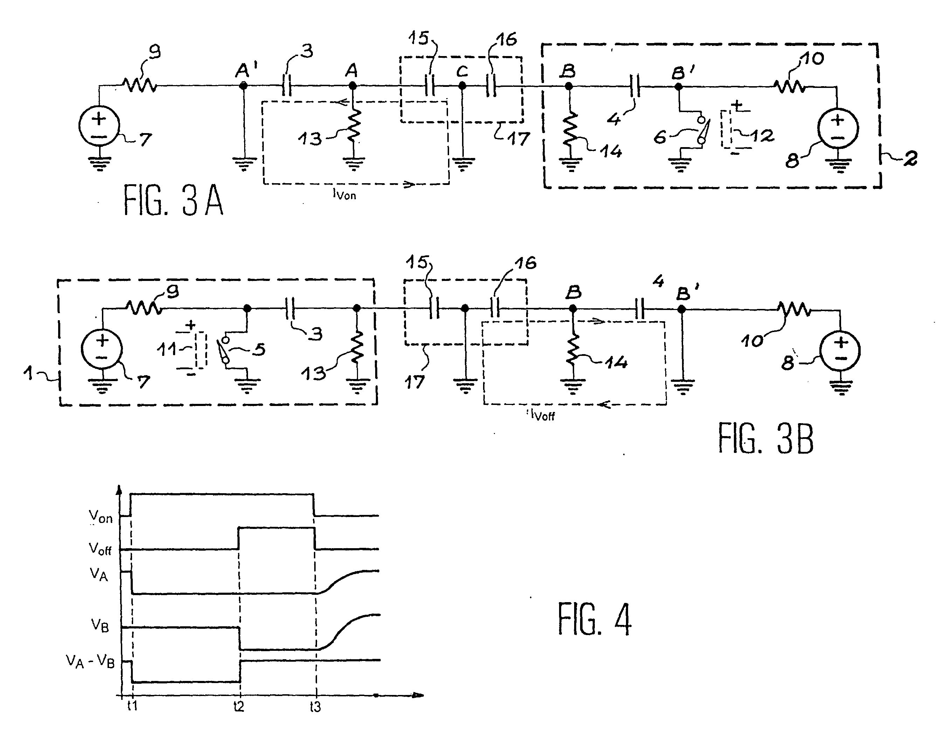

Sur les figures 3A et 3B, on a représenté le circuit de la figure 1 en cours de fonctionnement.

Plus précisément, la figure 3A montre l'état du circuit lorsque l'interrupteur 5 est fermé, mais que l'interrupteur 6 est ouvert.

On précise, avant tout, qu'à l'état initial le condensateur 3 est chargé, puisque le générateur de tension 7 l'a rechargé à travers les éléments résistifs 9 et 13, lorsque l'interrupteur 5 était ouvert (c'est-à-dire lorsque le circuit est à l'état initial, montré sur la figure 1).

Ensuite, à l'instant désiré, une impulsion de commande Vₒₙ est produite par le circuit de commande 11 pour causer la fermeture de l'interrupteur 5, ce qui permet de libérer l'énergie stockée dans le condensateur 3 sur la jonction A. Il apparaît alors, pendant un temps très bref, une tension V_{A} à la jonction A.

Ainsi, lorsque l'interrupteur 5 est commuté, le circuit de génération d'impulsions fonctionne comme montré sur la figure 3A. Un courant I_{Von} circule dans la boucle 21, dans le sens indiqué par des flèches, sur la figure 3A.

Pendant ce temps, le second générateur de tension 8 produit une tension permettant de recharger le second condensateur 4 à travers les éléments résistifs 10 et 14.

Après un certain temps, décalé par rapport à l'instant où l'impulsion Vₒₙ a été commandée, une impulsion de commande V_{off} est émise par le circuit de commande 12, de façon à commuter l'interrupteur 6 en position fermée, ce qui permet de libérer l'énergie stockée dans le condensateur 4 sur la jonction B. Il apparaît alors, pendant un temps très bref, une tension V_{B} sur la jonction B.

Lorsque l'interrupteur 6 est fermé, le circuit de génération d'impulsions fonctionne comme montré sur la figure 3B. Un courant I_{Voff} circule dans la boucle 20, dans le sens indiqué par les flèches, sur la figure 3B.

La figure 4 représente le diagramme temporel des tensions du circuit de génération d'impulsions des figures 1, 3A et 3B.

Plus précisément, la voie A de la figure 4 montre l'impulsion Vₒₙ émise par le circuit de commande 11 pour fermer temporairement l'interrupteur 5. Comme le montre cette voie A, l'interrupteur se ferme à l'instant t1 et s'ouvre à l'instant t3. Durant l'intervalle de temps t3 - t1, le courant Iᵥₒₙ stocké dans le condensateur 3 est libéré vers la cellule de Pockels 17.

Cette tension Vₒₙ, comme les tensions V_{off}, V_{A} et V_{B}, est de l'ordre de 20 Volts.

La voie B montre l'impulsion V_{off} émise au temps t2, par le circuit de commande 12 pour fermer temporairement l'interrupteur 6. A l'instant t3, l'interrupteur 6 s'ouvre. Ainsi, durant l'intervalle t3 - t2, le courant I_{Voff} stocké dans le condensateur 4 est libéré vers la cellule de Pockels 17.

La voie C de la figure 4 montre la tension V_{A} mesurée à la jonction A à partir de l'instant t1. Cette tension V_{A} est négative. Elle apparaît très rapidement à l'instant t1 et, par conséquent, présente un front descendant carré, tandis que le front montant, à partir de l'instant t3, est beaucoup plus lent.

La voie D de la figure 4 montre la tension V_{B} mesurée à la jonction B à partir de l'instant t2. Cette tension V_{B} est négative et apparaît très rapidement à l'instant t2. Elle présente donc un front descendant carré, tandis que le front montant, à partir de l'instant t3, est beaucoup plus lent.

Sur la voie E de la figure 4, on a représenté l'impulsion V_{A} - V_{B} obtenue à partir des tensions V_{A} et V_{B}. Comme on le voit sur cette figure, l'impulsion V_{A} - V_{B} a un front montant carré et un front descendant carré, ce qui signifie qu'elle a un temps de montée et un temps de descente très brefs.

En outre, l'intervalle de temps t1 - t2 peut être modifié suivant les besoins, en décalant l'instant t2 par rapport à t1, c'est-à-dire en décalant, dans le temps, l'instant où le circuit de commande 12 émet l'impulsion destinée à commuter l'interrupteur 6.

Ce circuit permet donc de délivrer, rapidement, des tensions de valeurs élevées et cela, pour un coût relativement peu élevé, puisque ce circuit est constitué de deux circuits générateurs identiques.

## Revendications

1. Circuit de génération d'impulsions de courant à haute tension à appliquer à un circuit de charge (17, 19) connecté entre deux points A et B, le circuit de génération comportant :
- un premier circuit d'alimentation (1) délivrant un premier courant (I_{Von}) dans le circuit de charge (17, 19) et comprenant un premier condensateur (3), connecté entre le point A et un point A', un premier interrupteur (5) connecté au point A' au premier condensateur (3) et un premier générateur de tension (7) connecté au travers d'une résistance (9) au premier condensateur (3) au point A', dans lequel la fermeture du premier interrupteur (3) autorise le passage du premier courant (I_{Von}) dans le circuit de charge (17, 19)
- un second circuit d'alimentation (2) connecté entre le point B et un point B' délivrant un second courant (I_{Voff}) dans le circuit de charge (17,19) et comportant un second condensateur (4) connecté entre le point B et un point B', un second interrupteur (6) connecté au point B' au second condensateur (4), la fermeture du second interrupteur (6) intervenant après la fermeture du premier interrupteur, dans lequel la fermeture du second interrupteur (6) autorise le passage du second courant (I_{Voff}) dans le circuit de charge (17, 19)
- le circuit de génération **caractérisé en ce qu'**il comporte un second générateur de tension (8) connecté au travers d'une résistance (10) au second condensateur (4) au point B', et **en ce que** le circuit de charge est constitué par une charge capacitive simple formant une cellule de pockel simple, les points A et B étant connectés à cette cellule ou par une charge capacitive double, formant une cellule de pockel double formée par deux cellules de pockel simples électriquement en série, et connectées entre elles par un point C et **en ce que** les premier et second interrupteurs sont déclenchés successivement avec un retard entre eux réglable.

## Patentansprüche

1. Erzeugungsschaltung von Hochspannungs-Stromimpulsen, anzulegen an eine Lastschaltung (17, 19), angeschlossen zwischen zwei Punkten A und B, wobei die Erzeugungsschaltung umfasst:
- eine erste, einen ersten Strom (I_{Von}) in die Lastschaltung (17, 19) liefernde Versorgungsschaltung (1), mit einem ersten Kondensator (3), angeschlossen zwischen einem Punkt A und einem Punkt A', einem ersten Schalter (5), in dem Punkt A' an den ersten Kondensator (3) angeschlossen, und einem ersten Spannungsgenerator (7), durch einen Widerstand (9) hindurch in dem Punkt A' an den ersten Kondensator (3) angeschlossen, bei der das Schließen des ersten Schalters (3) ermöglicht, den ersten Strom (I_{Von}) in die Lastschaltung (17, 19) fließen zu lassen,
- eine zweite, einen zweiten Strom (I_{Voff}) in die Lastschaltung (17, 19) liefernde Versorgungsschaltung (2), mit einem zweiten Kondensator (4), angeschlossen zwischen einem Punkt B und einem Punkt B', und einem zweiten Schalter (6), in dem Punkt B' an den zweiten Kondensator (4) angeschlossen, bei der das Schließen des zweiten Schalters (6) ermöglicht, den zweiten Strom (I_{Voff}) in die Lastschaltung (17, 19) fließen zu lassen,
wobei die Erzeugungsschaltung **dadurch gekennzeichnet ist, dass** sie einen zweiten Spannungsgenerator (8) umfasst, der durch einen Widerstand (10) hindurch in dem Punkt B' an den zweiten Kondensator (4) angeschlossen ist, und dadurch, dass die Lastschaltung aus einer einfachen kapazitiven Last besteht, eine einfache Pockels-Zelle bildend, wobei die Punkte A und B mit dieser Zelle verbunden sind, oder aus einer doppelten kapazitiven Last, eine doppelte Pockels-Zelle bildend, aus zwei elektrisch in Serie geschalteten einfachen Pockels-Zellen bestehend und zusammengeschaltet in einem Punkt C, und dadurch, dass der erste und der zweite Schalter sukzessive ausgelöst bzw. geschaltet werden, mit einer regelulierbaren gegenseitigen Verzögerung.

## Claims

1. Circuit for generating high voltage current pulses to be applied to a load circuit (17, 19) connected between two points (A and B), the generating circuit comprising:
- a first supply circuit (1) supplying a first current (Iᵥₒₙ) to the load circuit (17, 19) and comprising a first capacitor (3) connected between point A and a point A', a first switch (5) connected at point A' to the first capacitor (3) and a first voltage generator (7) connected across a resistor (9) to the first capacitor (3) at point A', in which the closing of the first switch (5) allows the passage of the first current (Iᵥₒₙ) into the load circuit (17, 19),
- a second supply circuit (2) connected between point B and a point B' supplying a second current (I_{voff}) to the load circuit (17, 19) and comprising a second capacitor (4) connected between point B end a point B', a second switch (6) connected at point B' to the second capacitor (4), the closing of the second switch (6) occurring after the closing of the first switch, in which the closing of the second switch (5) allows the passage of the second current (I_{voff}) into the load circuit (17, 19),
- the generating circuit being **characterized in that** it comprises a second voltage generator (8) connected amass a resistor (10) to the second capacitor (4) at point B' and **in that** the load circuit is constituted by a single capacitive load forming a single Pockels cell, points A and B being connected to said cell or by a double capacitive load, forming a double Pockels cell formed by two single Pockels cells which are electrically in series and connected to one another by a point C and **in that** the first and second switches are successively tripped with an adjustable time lag between them.
